# EUROPEAN PATENT SPECIFICATION

(11) **EP 3 264 871 B1**
(45) Date of publication and mention of the grant of the patent: **06.02.2019**
(21) Application number: 15883187.5
(22) Date of filing: 25.02.2015
(51) Int. Cl.: H05K 3/34, B23K 1/08, B23K 3/06, B23K 101/42

(54) **SOLDERING APPARATUS**
LÖTVORRICHTUNG
APPAREIL DE BRASAGE

(43) Date of publication of application: 03.01.2018
(73) Proprietor: FUJI Corporation, Chiryu Aichi (JP)
(72) Inventor: TANAKA Katsunori, Chiryu Aichi (JP); HAMANE Tsuyoshi, Chiryu Aichi (JP)
(74) Representative: Grünecker Patent- und Rechtsanwälte PartG mbB
(86) International application number: PCT/JP2015/055430
(87) International publication number: WO 2016/135891

(56) References cited:
- JP-A- 2007 073 786
- JP-A- 2011 228 635
- JP-A- 2015 000 405

## Description

### Technical Field

A technique disclosed in the present description relates to a soldering apparatus that solders a lead wire of an electronic component onto a circuit board.

### Background Art

Soldering apparatuses according to the related art are disclosed in PTL 1 and PTL 2. The soldering apparatuses include solder jetting devices disposed below holding surfaces, which hold circuit boards. The solder jetting devices have jet nozzles and XY-moving mechanisms, and the jet nozzles can be moved below soldering parts that are at different positions of the circuit boards. In addition, the solder jetting devices can control the height of molten solder ejected from solder jet nozzles. In the soldering apparatuses, precise soldering process can be performed with respect to the individual soldering parts since the heights of the molten solder ejected from the jet nozzles are controlled.

### Citation List

### Patent Literature

PTL 1: International Publication No. 2014/045370
PTL 2: JP-A-2008-109033

### Summary of Invention

### Technical Problem

In the soldering apparatuses of the related art described above, the jet nozzles are moved in an X-direction and/or a Y-direction in a state where molten solder is ejected from the jet nozzles. For this reason, there is a problem in which molten solder spills from the jet nozzles to the outside when the movement speeds of the jet nozzles are high. On the other hand, the spill of the molten solder from the jet nozzles can be prevented when the movement speeds of the jet nozzles are low but it takes more time for soldering when soldering multiple soldering parts.

An object of the present description is to provide a soldering apparatus that allows a jet nozzle to move at a rapid speed while reducing the spill of molten solder to the outside of the jet nozzle.

### Solution to Problem

A soldering apparatus disclosed in the present description solders a lead wire of an electronic component onto a circuit board by applying molten solder to the lead wire, which passes through a through-hole formed in the circuit board. The soldering apparatus has a solder tank, a jetting mechanism, an XY-direction moving mechanism, and a control device that controls the jetting mechanism and the XY-direction moving mechanism. The solder tank is disposed below a holding surface, on which the circuit board is held, and stores the molten solder. The jetting mechanism has a jet nozzle, which is provided in the solder tank and extends upwards from the solder tank toward the holding surface, and a pump, which pumps the molten solder stored in the solder tank to the jet nozzle, and jets the molten solder from the jet nozzle toward the holding surface by the pump being driven. The XY-direction moving mechanism moves the solder tank in an X-direction and a Y-direction, which are parallel to the holding surface. The control device controls the acceleration and deceleration of the solder tank according to the height of the molten solder protruding upwards from a tip of the jet nozzle or the height of the molten solder protruding upwards from the tip of the jet nozzle according to the acceleration and deceleration of the solder tank such that the molten solder does not spill to the outside of the jet nozzle, when the XY-direction moving mechanism is driven to move the solder tank in the X-direction and/or the Y-direction.

In the soldering apparatus, when the solder tank is moved, the acceleration and deceleration of the solder tank are controlled according to the height of the molten solder protruding upwards from the tip of the jet nozzle, or the height of the molten solder protruding upwards from the tip of the jet nozzle is controlled according to the acceleration and deceleration of the solder tank. For this reason, the acceleration and deceleration of the solder tank (that is, the jet nozzle) can be made large while reducing the spill of the molten solder from the jet nozzle provided in the solder tank to the outside. As a result, the jet nozzle can be moved at a rapid speed.

### Brief Description of Drawings

[Fig. 1] Fig. 1 is a perspective view illustrating a supply device that supplies electronic components to a circuit board and a soldering apparatus that solders the electronic components.
[Fig. 2] Fig. 2 is a view illustrating a configuration of the soldering apparatus.
[Fig. 3] Fig. 3 is a block diagram illustrating a configuration of a control system of the soldering apparatus.
[Fig. 4] Fig. 4 is a (first) schematic diagram illustrating operation of the soldering apparatus.
[Fig. 5] Fig. 5 is a (second) schematic diagram illustrating the operation of the soldering apparatus.
[Fig. 6] Fig. 6 is a (third) schematic diagram illustrating the operation of the soldering apparatus.
[Fig. 7] Fig. 7 is a (fourth) schematic diagram illustrating the operation of the soldering apparatus.
[Fig. 8] Fig. 8 is a (fifth) schematic diagram illustrating the operation of the soldering apparatus.
[Fig. 9] Fig. 9 is a (sixth) schematic diagram illustrating the operation of the soldering apparatus.

### Description of Embodiments

Main characteristics of an embodiment to be described are listed below.
(Characteristic 1) A soldering apparatus disclosed in the present description may control a jetting mechanism and control the height of molten solder protruding upwards from a tip of a jet nozzle according to the acceleration and deceleration of a solder tank, when an XY-direction moving mechanism is driven to move the solder tank in an X-direction and/or a Y-direction. According to such a configuration, the movement of the jet nozzle in the X-direction and/or the Y-direction can be increased in speed while reducing the spill of the molten solder from the jet nozzle to the outside.
(Characteristic 2) The soldering apparatus disclosed in the present description may have a Z-direction moving mechanism that moves the solder tank in a Z-direction orthogonal to a holding surface on which a circuit board is held. The control device may further control the Z-direction moving mechanism. According to such a configuration, the jet nozzle can be moved to an optimal position with respect to lead wires of an electronic component, which pass through through-holes in the circuit board. As a result, precise soldering can be performed with respect to the lead wires.
(Characteristic 3) The soldering apparatus disclosed in the present description may control the jetting mechanism such that the height of the molten solder protruding upwards from the tip of the jet nozzle when the XY-direction moving mechanism is driven to move the solder tank in the X-direction and/or the Y-direction is smaller than the height of the molten solder protruding upwards from the tip of the jet nozzle when the Z-direction moving mechanism is driven to move the solder tank in the Z-direction and the lead wires are soldered onto the circuit board. According to such a configuration, the movement in the X-direction and/or the Y-direction can be increased in speed while preventing the molten solder from spilling from the jet nozzle to the outside. In addition, since the height of the molten solder protruding upwards from the jet nozzle is increased when the lead wires are soldered, a distance between the jet nozzle and the circuit board when soldering can be made appropriate.
(Characteristic 4) The soldering apparatus disclosed in the present description may control the jetting mechanism such that the height of the molten solder protruding upwards from the tip of the jet nozzle when the XY-direction moving mechanism is driven to accelerate or decelerate the solder tank in the X-direction and/or the Y-direction is smaller than the height of the molten solder protruding upwards from the tip of the jet nozzle when the Z-direction moving mechanism is driven to move the solder tank in the Z-direction and the lead wires are soldered onto the circuit board. According to such a configuration, the movement in the X-direction and/or the Y-direction can be increased in speed while preventing the molten solder from spilling from the jet nozzle to the outside.

### Embodiment

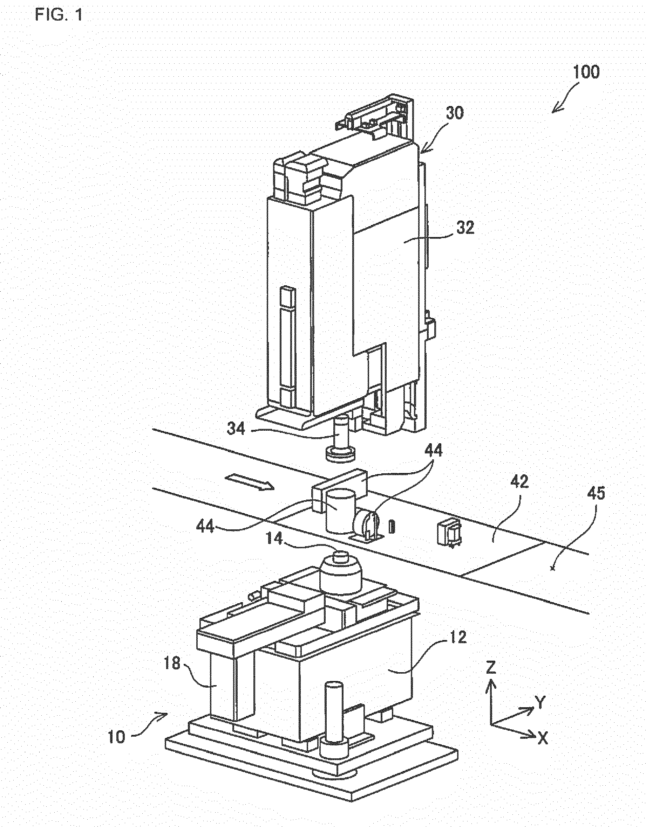

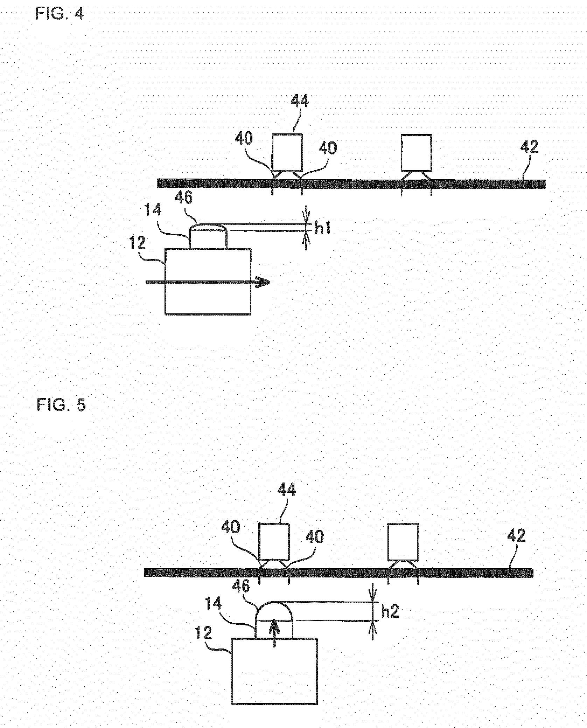

A soldering apparatus 10 of the embodiment will be described. First, a schematic configuration of a component mounting machine 100 equipped with the soldering apparatus 10 will be described. As illustrated in Fig. 1, the component mounting machine 100 includes a head 30 that mounts electronic components 44 on a circuit board 42 and the soldering apparatus 10 that solders the electronic components 44 onto the circuit board 42. Through-holes into which lead wires 40 (refer to Fig. 4 and the like) of the electronic components 44 are inserted are formed in the circuit board 42. The circuit board 42 is conveyed on a conveyance surface 45 (an example of the holding surface) by a conveyance device (not illustrated).

The head 30 sucks the electronic components 44 from a component supply device (not illustrated) and mounts the sucked electronic components 44 at predetermined positions on the circuit board 42. The head 30 includes a main body 32 and a suction nozzle 34, which is attached to the main body 32 so as to be movable in an up-down direction. A driving mechanism (not illustrated) allows the main body 32 to be movable in the X-direction and the Y-direction. The suction nozzle 34 can suck the electronic components 44. The driving mechanism (not illustrated) moves the suction nozzle 34 in the up-down direction with respect to the main body 32. When the electronic component 44 is sucked by the suction nozzle 34, the head 30 moves to a position where the electronic component 44 is mounted on the circuit board 42 (that is, a mounting position) . When the head 30 moves to the mounting position, the suction nozzle 34 falls and the lead wires 40 of the electronic component 44 are inserted into the through-holes in the circuit board 42. Consequently, the electronic component 44 is mounted on the circuit board 42.

The soldering apparatus 10 applies molten solder 46 to the lead wires 40 of the electronic component 44, which are inserted in the through-holes in the circuit board 42, to perform soldering onto the circuit board 42. The soldering apparatus 10 is disposed below the conveyance surface 45 on which the circuit board 42 is conveyed. The circuit board 42 that is conveyed on the conveyance surface 45 is positioned within the component mounting machine 100. The electronic components 44 are mounted on the positioned circuit board 42 by the head 30, and the soldering apparatus 10 performs soldering of the electronic components 44. Consequently, the electronic components 44 are soldered on the circuit board 42.

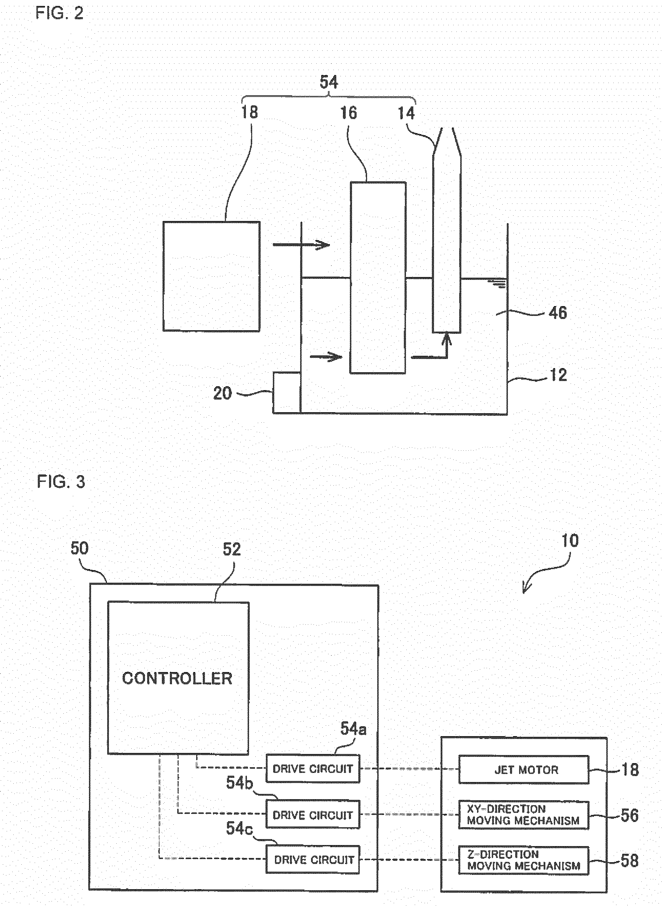

Next, the soldering apparatus 10 will be described in detail. As illustrated in Figs. 2 and 3, the soldering apparatus 10 includes a solder tank 12, a jetting mechanism 54, an XY-direction moving mechanism 56 that moves the solder tank 12 in the X-direction and the Y-direction which are parallel to the conveyance surface 45, a Z-direction moving mechanism 58 that moves the solder tank 12 in a Z-direction with respect to the conveyance surface 45, and a control device 50 that controls the jetting mechanism 54, the XY-direction moving mechanism 56, and the Z-direction moving mechanism 58.

The solder tank 12 stores the molten solder 46. The solder tank 12 is supported so as to be movable in the X-direction, the Y-direction, and the Z-direction within the mounting machine 100. A heater 20 is disposed on the wall surface of the solder tank 12. The heater 20 heats solder material stored inside the solder tank 12. Consequently, the solder material in the solder tank 12 reaches a molten state (that is, the molten solder 46).

The jetting mechanism 54 includes a jet nozzle 14 disposed above the solder tank 12, a pump 16 disposed in the solder tank 12, and a jet motor 18 disposed outside the solder tank 12. The jet nozzle 14 is in a cylindrical shape, and extends toward the conveyance surface 45 from the solder tank 12. An intake port is formed at a base (a lower end) of the jet nozzle 14 while an ejection port is formed at a tip (an upper end) of the jet nozzle, and a flow path that connects the ejection port and the intake port (a flow path in which the molten solder 46 flows) is formed inside the jet nozzle. The molten solder 46 taken in from the intake port flows in the flow path, which is in the jet nozzle 14, and spills to the outside of the jet nozzle 14 through the ejection port at the upper end of the jet nozzle 14.

The pump 16 sucks the molten solder 46 in the solder tank 12 and supplies the sucked molten solder 46 to the jet nozzle 14. The pump 16 is driven by the jet motor 18. The number of rotations of the jet motor 18 is controlled by the control device 50. With a change in the number of rotations of the jet motor 18, the flow rate per unit time of the molten solder 46 discharged from the pump 16 changes. When the flow rate of the molten solder 46 discharged from the pump 16 changes, the height of the molten solder 46 protruding from the tip of the jet nozzle 14 changes.

The XY-direction moving mechanism 56 includes a mechanism that moves the solder tank 12 in the X-direction and a mechanism that moves the solder tank 12 in the Y-direction. The XY-direction moving mechanism 56 includes a motor (not illustrated) and the motor is driven by the control device 50. By the control device 50 controlling the XY-direction moving mechanism 56, the solder tank 12 moves in the XY-directions and is positioned at a position where soldering is performed. A known mechanism can be used as the XY-direction moving mechanism 56.

The Z-direction moving mechanism 58 moves the solder tank 12 in the Z-direction and positions the solder tank 12 in the Z-direction. The Z-direction moving mechanism 58 includes a motor (not illustrated), and the motor is controlled by the control device 50. The position of the solder tank 12 with respect to the circuit board 42 (that is, the tip of the jet nozzle 14) is controlled by the control device 50 controlling the Z-direction moving mechanism 58. A known mechanism can be used as the Z-direction moving mechanism 58.

The control device 50 is connected to the jet motor 18, the XY-direction moving mechanism 56, and the Z-direction moving mechanism 58, and controls the jet motor 18, the XY-direction moving mechanism 56, and the Z-direction moving mechanism 58. The control device 50 includes a controller 52 and drive circuits 54a to 54c. The controller 52 is configured of, for example, a computer, including a CPU, a ROM, and a RAM, and executes a program stored in the ROM to control the jet motor 18, the XY-direction moving mechanism 56, and the Z-direction moving mechanism 58. That is, the controller 52 drives the jet motor 18 via the drive circuit 54a to control the flow rate of the molten solder 46 ejected from the jet nozzle 14. By controlling the flow rate of the molten solder 46, the height of the molten solder 46 protruding from the tip of the jet nozzle 14 is controlled. In addition, the controller 52 drives the XY-direction moving mechanism 56 via the drive circuit 54b and drives the Z-direction moving mechanism 58 via the drive circuit 54c to move the solder tank 12 in the XYZ-directions and to control the position of the solder tank 12 in the XYZ-directions.

Next, the operation of the control device 50 when the soldering apparatus 10 described above solders the lead wires 40 of the electronic component 44 onto the circuit board 42 will be described with reference to Fig. 4 to Fig. 9. First, the control device 50 drives the XY-direction moving mechanism 56 to move the solder tank 12 to a soldering part set in advance. At this time, the control device 50 controls the jet motor 18 and sets the height of the molten solder 46 protruding from the tip of the jet nozzle 14 to h1. The height h1 is set as a height, at which the molten solder 46 can be prevented from spilling to the outside of the jet nozzle 14, due to the acceleration and deceleration of the solder tank 12 in the X-direction and/or the Y-direction. In addition, a distance between the solder tank 12 and the circuit board 42 is set to a distance, at which a projected portion on a rear face of the circuit board 42 (the lead wires 40 of the electronic component 44 and the like) and the molten solder 46 protruding from the tip of the jet nozzle 14 do not come into contact with each other. The head 30 is in a state where the lead wires 40 of the electronic component 44 are inserted in the through-holes in the circuit board 42 by mounting the electronic component 44 on the soldering part of the circuit board 42. Consequently, the solder tank 12, for example, moves below the through-holes that are at positions where the soldering of the circuit board 42 is performed, as illustrated in Fig. 4.

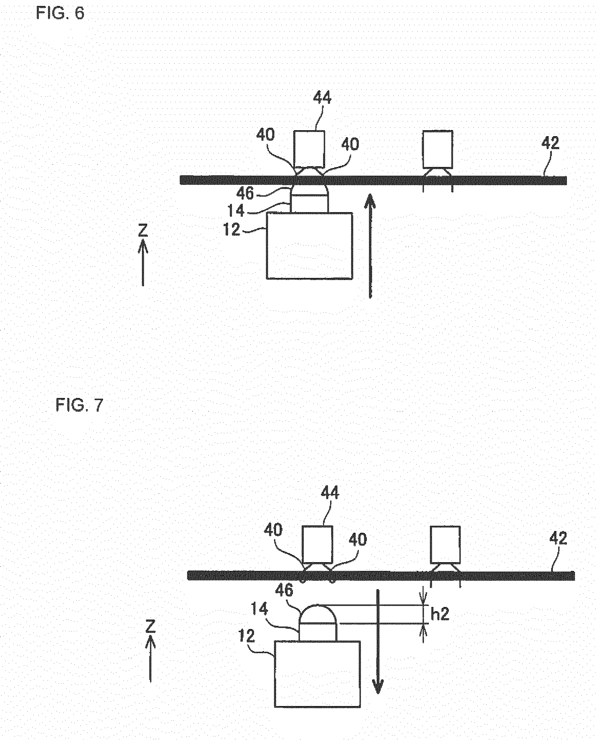

When the solder tank 12 is moved below the soldering part, the control device 50 increases the number of rotations of the jet motor 18 and raises the flow rate of the molten solder 46 discharged from the pump 16. Consequently, the height of the molten solder 46 protruding from the tip of the jet nozzle 14 is set to h2 (> h1), as illustrated in Fig. 5. The height h2 is set as a height sufficient to solder the lead wires 40 of the electronic component 44. When the height of the molten solder 46 is set to h2, the control device 50 drives the Z-direction moving mechanism 58 to move the solder tank 12 in the Z-direction, and the distance between the solder tank 12 and the circuit board 42 is set to a distance set in advance. As illustrated in Fig. 6, by moving the solder tank 12 in the Z-direction, the molten solder 46 is brought into contact with the lead wires 40 of the electronic component 44 inserted in the circuit board 42 and the lead wires 40 of the electronic component 44 are soldered onto the circuit board 42. When the solder tank 12 is moved in the Z-direction, the height of the molten solder 46 protruding from the tip of the jet nozzle 14 is kept at h2.

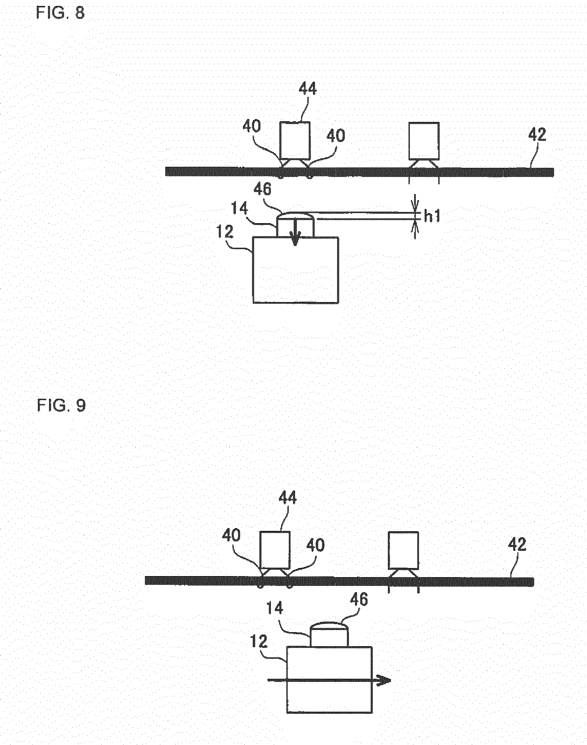

When the soldering of the electronic component 44 is terminated, the control device 50 drives the Z-direction moving mechanism 58 to move the solder tank 12 in a direction of separating away from the circuit board 42 (-Z-direction), as illustrated in Fig. 7. At this time, the height of the molten solder 46 protruding from the tip of the jet nozzle 14 is kept at h2. In addition, a distance at which the solder tank 12 is fallen is set so as to become a height at which the molten solder 46 does not come into contact with the projected portion on the rear face of the circuit board 42 (the lead wires 40 of the electronic component 44 and the like) . After then, the control device 50 decreases the number of rotations of the jet motor 18, and decreases the flow rate of the molten solder 46 discharged from the pump 16. Consequently, the height of the molten solder 46 protruding from the tip of the jet nozzle 14 becomes h1 as illustrated in Fig. 8. As described above, the height h1 is set as a height at which the molten solder 46 does not spill to the outside of the soldering apparatus 10 when the solder tank 12 is moved in the XY-directions. When the height of the molten solder 46 is set to h1, the control device 50 drives the XY-direction moving mechanism 56 as illustrated in Fig. 9 to move the solder tank 12 to the next soldering part (a state illustrated in Fig. 9) . Consequently, the solder tank 12 is moved to a part at which the next soldering is performed (below through-holes in which the next lead wires of an electronic component are inserted). By repeating a series of operation pieces described above, the control device 50 solders the multiple electronic components 44 onto the circuit board 42.

In the soldering apparatus 10 of the embodiment, the height of the molten solder 46 protruding from the tip of the jet nozzle 14 is set to h1 when the solder tank 12 is moved in the X-direction and/or the Y-direction. As a result, the molten solder can be prevented from spilling from the jet nozzle 14 to the outside. In addition, since the height of the molten solder 46 is set to a low value of h1, the solder tank 12 can be moved at a rapid speed in the X-direction and/or the Y-direction. As a result, since the movement time of the solder tank 12 in the X-direction and/or the Y-direction is shortened, the time required for a series of operation pieces of soldering can be shortened and the efficiency of a soldering work can be heightened.

In addition, in the soldering apparatus 10 of the embodiment, the height of the molten solder 46 protruding from the tip of the jet nozzle 14 is set to h1 (<h2) when the solder tank 12 is moved in the X-direction and/or the Y-direction. For this reason, the distance between the solder tank 12 and the circuit board 42 when the solder tank 12 is moved in the X-direction and/or the Y-direction is set to a short distance. That is, when the height of the molten solder 46 protruding from the jet nozzle 14 is large, the distance between the circuit board 42 and the solder tank 12 is required to become large in order to ensure that the molten solder 46 and the projected portion on the rear face of the circuit board 42 (other lead wires 40 of the electronic component 44 and the like) do not come into contact with each other. On the other hand, since the height of the molten solder 46 protruding from the jet nozzle 14 is small in the embodiment, it can be ensured that the molten solder 46 and the projected portion on the rear face of the circuit board 42 (other lead wires 40 of the electronic component 44 and the like) do not come into contact with each other even when the distance between the circuit board 42 and the solder tank 12 is short. As a result, a distance at which the solder tank 12 is risen/fallen can be shortened and time required for soldering can be further shortened.

Although the control device 50 controls the height of the molten solder 46 protruding upwards from the tip of the jet nozzle 14 according to the acceleration and deceleration of the solder tank 12, which cause the solder tank 12 to move in the X-direction and/or the Y-direction, in the embodiment described above, the technique disclosed in the present description is not limited to such an example.

For example, the control device 50 may control the acceleration and deceleration of the solder tank 12 according to the height of the molten solder 46 protruding upwards from the tip of the jet nozzle 14. Even in such a configuration, molten solder can be prevented from spilling to the outside of the tip of the jet nozzle 14. In a case where such a configuration is adopted, the height of the molten solder 46 protruding upwards from the tip of the jet nozzle 14 when the solder tank 12 is moved (accelerated or decelerated) in the X-direction and/or the Y-direction and the height of the molten solder 46 protruding upwards from the tip of the jet nozzle 14 when the solder tank 12 is moved in the Z-direction can be made the same. Consequently, the control of the jet motor 18 can be performed simply. In addition, the height of the molten solder 46 protruding upwards from the tip of the jet nozzle 14 when the solder tank 12 is moved (accelerated or decelerated) in the X-direction and/or the Y-direction is not required to be constant, and the height of the molten solder 46 may change according to the acceleration and deceleration of the solder tank 12.

Although the embodiment has been described in detail hereinbefore, the embodiment is merely an example and does not limit the scope of the claims.

## Claims

1. A soldering apparatus (10) for soldering a lead wire (40) of an electronic component (44) onto a circuit board (42) by applying molten solder (46) to the lead wire (40), which passes through a through-hole formed in the circuit board (42), the apparatus comprising:
a solder tank (12) for storing molten solder (46), which is disposed below a holding surface on which the circuit board (42) can be held;
a jetting mechanism (54) that has a jet nozzle (14), which is provided in the solder tank (12) and extends upwards from the solder tank (12), such that in use it extends toward the holding surface, and a pump (16), for pumping the molten solder (46) stored in the solder tank (12) to the jet nozzle (14), and for jetting, in use, the molten solder (46) from the jet nozzle (14) toward the holding surface by the pump (16) being driven;
an XY-direction moving mechanism (56) for moving the solder tank (12) in an X-direction and a Y-direction, which, in use, are parallel to the holding surface; and
**characterized by**
a control device (50) for controlling the jetting mechanism (54) and the XY-direction moving mechanism (56),
wherein the control device (50) is adapted to control the acceleration and deceleration of the solder tank (12) according to the height of the molten solder (46) protruding upwards from a tip of the jet nozzle (14) or the height of the molten solder (46) protruding upwards from the tip of the jet nozzle (14) according to the acceleration and deceleration of the solder tank (12) such that the molten solder (46) does not spill to the outside of the jet nozzle (14), when the XY-direction moving mechanism (56) is driven to move the solder tank (12) in the X-direction and/or the Y-direction.

2. The soldering apparatus (10) according to Claim 1,
wherein the control device (50) is adapted to control the height of the molten solder (46) protruding upwards from the tip of the jet nozzle (14) according to the acceleration and deceleration of the solder tank (12) by controlling the jetting mechanism (54), when the XY-direction moving mechanism (56) is driven to move the solder tank (12) in the X-direction and/or the Y-direction.

3. The soldering apparatus (10) according to Claim 1 or 2, further comprising:
a Z-direction moving mechanism (58) for moving the solder tank (12) in a Z-direction orthogonal to the holding surface,
wherein the control device (50) further is adapted to control the Z-direction moving mechanism (58).

4. The soldering apparatus (10) according to Claim 3,
wherein the control device (50) is adapted to control the jetting mechanism (54) such that the height of the molten solder (46) protruding upwards from the tip of the jet nozzle (14) when the XY-direction moving mechanism (58) is driven to move the solder tank (12) in the X-direction and/or the Y-direction is smaller than the height of the molten solder (46) protruding upwards from the tip of the jet nozzle (14) when the Z-direction moving mechanism (58) is driven to move the solder tank (12) in the Z-direction and to solder the lead wire (40) onto the circuit board (42).

5. The soldering apparatus (10) according to Claim 3 or 4,
wherein the control device (50) is adapted to control the jetting mechanism (54) such that the height of the molten solder (46) protruding upwards from the tip of the jet nozzle (14) when the XY-direction moving mechanism (56) is driven to accelerate or decelerate the solder tank (12) in the X-direction and/or the Y-direction is smaller than the height of the molten solder (46) protruding upwards from the tip of the jet nozzle (14) when the Z-direction moving mechanism (58) is driven to move the solder tank (12) in the Z-direction and to solder the lead wire (40) onto the circuit board (42).

## Patentansprüche

1. Eine Lötvorrichtung (10) zum Löten eines Leitungsdrahts (40) einer elektronischen Komponente (44) auf eine Leiterplatte (42) durch Aufbringen von geschmolzenem Lötmittel (46) auf den Leitungsdraht (40), welcher durch ein, in der Leiterplatte (42) ausgebildetes Durchgangsloch verläuft, wobei die Vorrichtung umfasst:
einen Lotbehälter (12) zum Lagern von geschmolzenem Lot (46), der unter einer Haltefläche angeordnet ist, auf der die Leiterplatte (42) gehalten werden kann;
einen Ausstoßmechanismus (54), der eine Strahldüse (14) aufweist, die im Lotbehälter (12) angeordnet ist und sich vom Lotbehälter (12) nach oben erstreckt, so dass er sich im Gebrauch in Richtung der Haltefläche erstreckt, und eine Pumpe (16), um das geschmolzene Lot (46), welches in dem Lotbehälter (12) gelagert ist, zu der Strahldüse (14) zu pumpen, und um das geschmolzene Lot (46) bei Gebrauch aus der Strahldüse (14) in Richtung der Haltefläche zu spritzen, indem die Pumpe (16) angetrieben wird;
einen XY-Richtung Bewegungsmechanismus (56) zum Bewegen des Lotbehälters (12) in X-Richtung und in Y-Richtung, welche im Gebrauch parallel zur Haltefläche sind; und
**dadurch gekennzeichnet, dass**
eine Steuervorrichtung (50) zum Steuern des Ausstoßmechanismus (54) und des XY-Richtung Bewegungsmechanismus (56),
wobei die Steuervorrichtung (50) dazu eingerichtet ist, die Beschleunigung und Verzögerung des Lotbehälters (12) entsprechend der Höhe des aus einer Spitze der Strahldüse (14) nach oben ragenden geschmolzenen Lots (46) oder der Höhe des geschmolzenes Lot (46), welches von der Spitze der Strahldüse (14) nach oben vorsteht, zu steuern, entsprechend der Beschleunigung und Verzögerung des Lotbehälters (12), so dass das geschmolzene Lot (46) nicht aus der Strahldüse (14) austritt, wenn der XY-Richtung Bewegungsmechanismus (56) angetrieben wird, um den Lotbehälters (12) in X-Richtung und / oder in Y-Richtung zu bewegen.

2. Die Lötvorrichtung (10) gemäß Anspruch 1,
wobei die Steuervorrichtung (50) dazu eingerichtet ist, die Höhe des von der Spitze der Strahldüse (14) nach oben ragenden geschmolzenen Lots (46) entsprechend der Beschleunigung und Verzögerung des Lotbehälter (12) durch Steuern des Ausstoßmechanismus (54) zu steuern, wenn der der XY-Richtung Bewegungsmechanismus (56) angetrieben wird, um den Lotbehälter (12) in der X-Richtung und / oder in der Y-Richtung zu bewegen.

3. Die Lötvorrichtung (10) gemäß Anspruch 1 oder 2, des weiteren umfassend:
einen Z-Richtung Bewegungsmechanismus (58) zum Bewegen des Lotbehälters (12) in einer Z-Richtung orthogonal zur Haltefläche,
wobei die Steuervorrichtung (50) ferner dazu eingerichtet ist, den Z-Richtung Bewegungsmechanismus (58) zu steuern.

4. Die Lötvorrichtung (10) gemäß Anspruch 3,
wobei die Steuervorrichtung (50) eingerichtet ist den Ausstoßmechanismus (54) derart zu steuern, dass die Höhe des geschmolzenen Lots (46), welches von der Spitze der Strahldüse (14) nach oben ragt, wenn der XY-Richtung Bewegungsmechanismus (56) angetrieben wird, um den Lotbehälter (12) in die X-Richtung und / oder in die Y-Richtung zu bewegen, kleiner ist, als die Höhe des geschmolzenen Lots (46), das von der Spitze der Strahldüse (14) nach oben ragt, wenn der Z-Richtung Bewegungsmechanismus (58) angetrieben wird, um den Lotbehälter (12) in der Z-Richtung zu bewegen und den Leitungsdraht (40) auf die Leiterplatte (42) zu verlöten.

5. Die Lötvorrichtung (10) gemäß Anspruch 3 oder 4,
wobei die Steuervorrichtung (50) eingerichtet ist den Ausstoßmechanismus (54) derart zu steuern, dass die Höhe des geschmolzenen Lots (46), welches von der Spitze der Strahldüse (14) nach oben ragt, wenn der XY-Richtung Bewegungsmechanismus (56) angetrieben wird, um den Lotbehälter (12) in die X-Richtung und / oder in die Y-Richtung zu beschleunigen oder abzubremsen, kleiner ist, als die Höhe des geschmolzenen Lots (46), welches von der Spitze der Strahldüse (14) nach oben ragt, wenn der Z-Richtungs-Bewegungsmechanismus (58) angetrieben wird, um den Lötmittelbehälter (12) in Z-Richtung zu bewegen und den Leitungsdraht (40) auf die Leiterplatte (42) zu verlöten.

## Revendications

1. Dispositif de brasage (10) pour braser un fil conducteur (40) d'un composant électronique (44) sur une carte de circuits (42) en appliquant une brasure fondue (46) au fil conducteur (40), qui traverse un trou traversant formé dans la carte de circuits (42), le dispositif comprenant :
un réservoir de brasure (12) pour stocker de la brasure fondue (46), qui est placé au-dessous d'une surface de maintien sur laquelle la carte de circuits (42) peut être maintenue ;
un mécanisme de jet (54) qui dispose d'une buse de jet (14), qui est installée dans le réservoir de brasure (12) et s'étend vers le haut depuis le réservoir de brasure (12), de sorte qu'en fonctionnement elle s'étend vers la surface de maintien, et une pompe (16), pour pomper la brasure fondue (46) stockée dans le réservoir de brasure (12) vers la buse de jet (14), et pour projeter, en fonctionnement, la brasure fondue (46) de la buse de jet (14) vers la surface de maintien par un entraînement de la pompe (16) ;
un mécanisme de déplacement dans une direction XY (56) pour déplacer le réservoir de brasure (12) dans une direction X et une direction Y, qui, en fonctionnement, sont parallèles à la surface de maintien ; et
**caractérisé par**
un dispositif de contrôle (50) pour contrôler le mécanisme de jet (54) et le mécanisme de déplacement dans une direction XY (56),
dans lequel le dispositif de contrôle (50) est adapté pour contrôler l'accélération et la décélération du réservoir de brasure (12) selon la hauteur de la brasure fondue (46) dépassant vers le haut depuis une extrémité de la buse de jet (14) ou la hauteur de la brasure fondue (46) dépassant vers le haut depuis l'extrémité de la buse de jet (14) selon l'accélération et la décélération du réservoir de brasure (12) de sorte que la brasure fondue (46) ne déborde pas hors de la buse de jet (14), lorsque le mécanisme de déplacement dans une direction XY (56) est entraîné pour déplacer le réservoir de brasure (12) dans la direction X et/ou la direction Y.

2. Le dispositif de brasage (10) selon la revendication 1,
dans lequel le dispositif de contrôle (50) est adapté pour contrôler la hauteur de la brasure fondue (46) dépassant vers le haut depuis l'extrémité de la buse de jet (14) selon l'accélération et la décélération du réservoir de brasure (12) en contrôlant le mécanisme de jet (54), lorsque le mécanisme de déplacement dans une direction XY (56) est entraîné pour déplacer le réservoir de brasure (12) dans la direction X et/ou la direction Y.

3. Le dispositif de brasage (10) selon la revendication 1 ou 2, comprenant en outre :
un mécanisme de déplacement dans une direction Z (58) pour déplacer le réservoir de brasure (12) dans une direction Z orthogonale à la surface de maintien,
dans lequel le dispositif de contrôle (50) est adapté en outre pour contrôler le mécanisme de déplacement dans une direction Z (58).

4. Le dispositif de brasage (10) selon la revendication 3,
dans lequel le dispositif de contrôle (50) est adapté pour contrôler le mécanisme de jet (54) de sorte que la hauteur de la brasure fondue (46) dépassant vers le haut depuis l'extrémité de la buse de jet (14) lorsque le mécanisme de déplacement dans une direction XY (58) est entraîné pour déplacer le réservoir de brasure (12) dans la direction X et/ou la direction Y est inférieure à la hauteur de la brasure fondue (46) dépassant vers le haut depuis l'extrémité de la buse de jet (14) lorsque le mécanisme de déplacement dans une direction Z (58) est entraîné pour déplacer le réservoir de brasure (12) dans la direction Z et pour braser le fil conducteur (40) sur la carte de circuits (42).

5. Le dispositif de brasage (10) selon la revendication 3 ou 4,
dans lequel le dispositif de contrôle (50) est adapté pour contrôler le mécanisme de jet (54) de sorte que la hauteur de la brasure fondue (46) dépassant vers le haut depuis l'extrémité de la buse de jet (14) lorsque le mécanisme de déplacement dans une direction XY (56) est entraîné pour accélérer ou décélérer le réservoir de brasure (12) dans la direction X et/ou la direction Y est inférieure à la hauteur de la brasure fondue (46) dépassant vers le haut depuis l'extrémité de la buse de jet (14) lorsque le mécanisme de déplacement dans une direction Z (58) est entraîné pour déplacer le réservoir de brasure (12) dans la direction Z et pour braser le fil conducteur (40) sur la carte de circuits (42).
